# EUROPEAN PATENT APPLICATION

(11) **EP 4 672 328 A1**
(43) Date of publication of application: **31.12.2025**
(21) Application number: 25185192.9
(22) Date of filing: 25.06.2025
(51) Int. Cl.: H01L 23/482

(54) **BIPOLAR JUNCTION TRANSISTOR**

(30) Priority: 25.06.2024 GB 202409109
(71) Applicant: Diodes Incorporated, Plano, Texas 75024 (US)
(72) Inventor: Mott, Matthew, Oldham OL9 9LL (GB); Jerred, Paul, Oldham OL9 9LL (GB); Riley, Lee, Oldham OL9 9LL (GB)
(74) Representative: Marks & Clerk LLP

(57) **Abstract**

A bipolar junction transistor (BJT) comprising a semiconductor region and a plurality of metal contacts, located on a top surface of the semiconductor region, where the plurality of metal contacts comprise one or more first metal contacts that are in contact with one or more emitter regions and one or more second metal contacts that are in contact with an upper surface of a body region of the semiconductor region. One or more insulating structures are located on a top surface of the semiconductor region, where the insulating structures isolate the one or more first metal contacts from the one or more second metal contacts. A metal layer is located over the insulating structures, where the metal layer is in contact with one or more first metal contacts and is isolated from the one or more second metal contacts by the insulating structures.

## Description

### Technical Field

The disclosure relates to a semiconductor device and a method of manufacturing a semiconductor device. Particularly, but not exclusively, the disclosure relates to a bipolar junction transistor (BJT) semiconductor device.

### Background

A bipolar junction transistor (BJT) is a three-terminal semiconductor power device, which comprises two pn-junctions formed by sandwiching either a p-type or an n-type semiconductor material between a pair of opposite type semiconductors.

The latest generation of bipolar junction transistors offer lower specific on-resistance than metal-oxide-semiconductor field-effect transistors (MOSFETs). The ruggedness to electrostatic discharge (ESD) of bipolar junction transistors, along with their very low specific on-resistance, also make them very cost effective alternatives to MOSFETs.

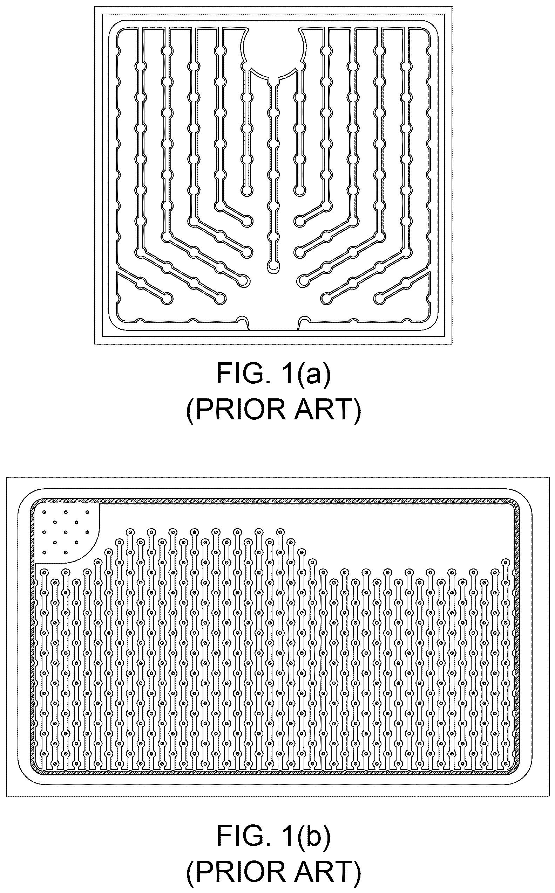

Figure 1(a) shows a top view of a bipolar junction transistor (BJT), and Figure 1(b) shows a top view of a BJT device. The tracks to the emitter and base contacts are formed in an interdigitated arrangement, within a single layer metal and with separate emitter and base bonding areas.

It is advantageous to reduce power loss and increase efficiency within a packaged BJT device when operating as a saturated switch. Two factors accounting for power loss are the combined specific area emitter to collector resistance of the BJT device and the resistance of the package internal wire connectors.

Existing devices are unable to feature enlarge the BJT emitter bond pad area to accommodate low resistance multiple bond wires or ribbon bond connection without reducing the active area and increasing the specific area resistance of the BJT device.

### Summary

Aspects and preferred features are set out in the accompanying claims.

The device of the present disclosure addresses the above-recited problem of reducing power loss and increasing efficiency within a packaged BJT device.

According to a first aspect of the disclosure, there is provided a bipolar junction transistor (BJT) comprising:
a semiconductor region, comprising:
   a drift region of a first conductivity type;
   a body region of a second conductivity type, opposite to the first conductivity type, disposed over the drift region;
   one or more emitter regions of a first conductivity type disposed within the body region; and
a plurality of metal contacts, located on a top surface of the semiconductor region, wherein the plurality of metal contacts comprise one or more first metal contacts that are in contact with the one or more emitter regions and one or more second metal contacts that are in contact with an upper surface of the body region;
one or more insulating structures located on a top surface of the semiconductor region, wherein the insulating structures isolate the one or more first metal contacts from the one or more second metal contacts; and
a metal layer located over the insulating structures, wherein the metal layer is in contact with one or more first metal contacts and is isolated from the one or more second metal contacts by the insulating structures.

MOSFET transistors are voltage controlled in contrast to bipolar transistors, which are current controlled. This important difference affects the materials that can be used for the gate and base electrodes of MOSFETs and BJTs. This means that, unlike MOSFETs, which use doped polysilicon electrodes for the gate, the base and emitter electrodes of BJTs are generally formed of high conductivity metals such as Aluminium. High conductivity metals tend to be soft and therefore easily deformed by bonding forces, unlike polysilicon, which is harder. Additionally, existing BJTs, such as that shown in Figures 1(a) and 1(b) generally have tracks to the emitter and base contacts formed in an interdigitated arrangement, which cannot be used with ribbon bond technology. The configuration of the herein disclosed device provides isolation between the base and emitter contacts, and allows the base contact to be formed outside of the active area of the device.

Due to these differences, existing matrix BJTs are not suitable for ribbon bonding over the active area.

The structure of the herein disclosed device allows low resistance ribbon bond technology to used, thereby reducing package resistance. This provides a low saturation voltage BJT with enhanced packaging flexibility.

The load bearing interlayer dielectric structure of the herein disclosed device allows ribbon bond technology to be used on a matrix bipolar transistor, by keeping the base and emitter metal tracks isolated from each other.

The one or more first metal contacts and the one or more second metal contacts may be laterally spaced from each other in a first direction. The one or more second metal contacts may be vertically spaced from the metal layer in a second direction, where the second direction is perpendicular to the first direction. This provides a two-layer metal structure, with the metal layer vertically separated from the base metal contacts.

As well as withstanding bonding forces, the two-layer metal structure means that the area of the device that can be used as an emitter bond area is significantly enlarged without sacrificing the active area of the device or without increasing specific area resistance.

The bipolar junction transistor may be configured such that, when in use, current flows vertically between the one or more first metal contacts and the metal layer, and current flows within the one or more second metal contacts laterally through the device. In other words, the bipolar junction transistor may be a vertical bipolar junction transistor.

There is no requirement for interdigitated connections to first metal contacts (emitter contacts) to be located between connections to second metal contacts (base contacts). Instead, connection to first metal contacts can be made vertically through the metal layer, and connections to the second metal contacts can be made laterally through a lower layer of the device to the metal layer. This means that, in comparison to state-of-the-art devices, there is no lateral voltage drop across adjacent base contacts and emitter contacts.

As each of the first metal contacts (the emitter contacts) are connected vertically to the metal layer, this improves the uniformity of the connection to the emitter contacts and allows for an optimum emitter to base bias across the device.

The bipolar junction transistor may comprise a base terminal connection. The one or more second metal contacts may be connected to the base terminal via a metal track extending along a perimeter of the bipolar junction transistor. The metal track may extend substantially around a perimeter of the device, or may only extend partially around a perimeter of the device. By connecting the second metal contacts to the base terminal connection via a metal track around the perimeter of the device, the connections to the second metal contacts can be more uniform and can be optimised.

Each second metal contact of the one or more second metal contacts may be connected to the metal track via a plurality of connections extending in at least two different directions.

Each second metal contact of the one or more second metal contacts may be directly connected to a portion of the metal track extending along a side of the bipolar junction transistor that is closest to said each second metal contact of the one or more second metal contacts. This allows for shorter connections to the second metal contacts.

The one or more insulating structures may comprise a plurality of first insulating regions located on a top surface of the semiconductor region. Each first insulating region may be located laterally between a first metal contact of the one or more first metal contacts and a second metal contact of the one or more second metal contacts. The one or more insulating structures may further comprise one or more dielectric regions located over the one or more second metal contacts. The dielectric regions may be at least partly located over the plurality of first insulating regions.

The one or more dielectric regions may overlap an upper surface of the one or more first metal contacts. In other words, at least a portion of the one or more dielectric regions may overhang a top surface of the first metal contacts. This provides strength to the device.

The one or more dielectric regions may comprise an upper dielectric region supported by two or more laterally spaced columnar structures. Each columnar structure may be formed over a first insulating region.

Mechanical support to the dual-layer metal electrode structures to withstand higher bonding forces is achieved by the laterally spaced columnar structures, which act as support pillars within the interlayer dielectric region.

A width of the two or more columnar structures may be at least 2µm. This provides strength to the device.

A spacing between adjacent columnar structures may be 5µm to 20µm. More preferably, a spacing between adjacent columnar structures may be 12µm.

An upper surface of the one or more dielectric regions may be planarised. This allows a substantially flat metal layer to be formed over the dielectric region, and improves the ease of contact to the metal layer.

The insulating structures may be formed of silicon dioxide. This provides strength to the device to withstand bonding forces.

The metal layer may have a larger surface area than the one or more first metal contacts. This allows a ribbon bond to be connected to the metal layer.

The bipolar junction transistor may further comprise a ribbon bond formed over the metal layer.

An edge length of a top surface of the metal layer and/or the active area of the semiconductor chip may have a length of greater than 0.25mm, more preferably greater than 0.5mm, more preferably greater than 1mm.

The ribbon bond may have a width of greater than 500µm, more preferably greater than 750µm. The ribbon bond may have an uncompressed height of greater than 50µm, more preferably greater than 100µm. The ribbon bond may have an area greater than 0.1mm², more preferably greater than 0.2 mm² in contact with the metal layer.

The bipolar junction transistor may further comprise a clip bond formed over the metal layer. The clip bond may have a width of greater than 500µm, more preferably greater than 750µm. The clip bond may have an uncompressed height of greater than 100µm, more preferably greater than 150µm. The clip bond may have an area greater than 0.2mm², more preferably greater than 0.4mm² in contact with the metal layer.

A spacing between adjacent second metal contacts of the one or more second metal contacts may be between 20µm to 100µm. More preferably, a spacing between adjacent second metal contacts of the one or more second metal contacts may be between 35µm to 50µm.

An emitter terminal connection may be formed on an upper surface of the device over the metal layer. The emitter terminal connection may extend substantially over the active area of the device.

The bipolar junction transistor may further comprise a base terminal connection formed on an upper surface of the device. The base terminal connection may not extend over the metal layer.

According to a further aspect of the disclosure, there is provided a method of manufacturing a bipolar junction transistor (BJT), the method comprising:
forming a semiconductor region, comprising:
   a drift region of a first conductivity type;
   a body region of a second conductivity type, opposite to the first conductivity type, disposed over the drift region;
   one or more emitter regions of a first conductivity type disposed within the body region; and
forming a plurality of metal contacts, located on a top surface of the semiconductor region, wherein the plurality of metal contacts comprise one or more first metal contacts that are in contact with the one or more emitter regions and one or more second metal contacts that are in contact with an upper surface of the body region;
forming one or more insulating structures located on a top surface of the semiconductor region, wherein the insulating structures isolate the one or more first metal contacts from the one or more second metal contacts;
forming a metal layer located over the insulating structures, wherein the metal layer is in contact with the one or more first metal contacts and is isolated from the one or more second metal contacts by the insulating structures.

Forming the one or more insulating structures may comprise forming one or more dielectric regions comprising an upper dielectric region supported by two or more laterally spaced columnar structures. The upper dielectric region may have a thickness that is at least half the width of the columnar structures. This ensures that breadloafing, which may occur when depositing the dielectric region, allows the gap between adjacent metal contacts to be filled to form the support pillars.

After forming the one or more dielectric regions, the method may further comprise planarising an upper surface of the upper dielectric region.

The devices of the present disclosure are advantageous over state-of-the-art devices for at least the following reasons:
- the size of the device can be reduced whilst having improved high current performance;
- ribbon bonding can be implemented on a matrix bipolar junction transistor. This improves the saturation collector-emitter voltage (V_{ce}(sat)), and the specific area ON resistance;
- current distribution across the matrix bipolar junction transistor is improved by means of the dual-layer metal structure, including a base connected metal mesh layout and emitter connected top metal layers. This improves switching performance.

### Brief Description of the Drawings

Some preferred embodiments of the disclosure will now be described, by way of example only, and with reference to the accompanying drawings, in which:
Figure 1(a) shows a top view of a bipolar junction transistor (BJT);
Figure 1(b) shows an alternative top view of a bipolar junction transistor (BJT);
Figure 2 shows a cross-section of a BJT according to an embodiment of the disclosure;
Figure 3 shows a scanning electron microscope image of a cross-section of a BJT according to an embodiment of the disclosure;
Figure 4(a) shows a top-view of a BJT according to an embodiment of the disclosure;
Figure 4(b) shows an alternative top-view of a BJT according to an embodiment of the disclosure;
Figure 5 shows a magnified top-view of the BJT shown in Figure 4;
Figure 6 shows a further magnified top-view of the BJT shown in Figure 5;
Figure 7(a) shows a cross-section through the BJT device shown in Figure 6;
Figure 7(b) shows an alternative cross-section through the BJT device shown in Figure 6;
Figure 8 shows a magnified top-view of an alternative BJT according to an embodiment of the disclosure;
Figure 9 shows a magnified top-view of the base pad area of the BJT shown in Figure 4;
Figure 10(a) shows a cross-section through the BJT device shown in Figure 9;
Figure 10(b) shows an alternative cross-section through the BJT device shown in Figure 9;
Figure 11(a) shows schematically a top-view and side view of ribbon bonding to a BJT device as disclosed herein;
Figure 11(b) shows schematically a top-view and side view of clip bonding to a BJT device as disclosed herein;
Figure 11(c) shows a side-view of a clip bond, such as that shown in Figure 11(b).

### Detailed Description of the Preferred Embodiments

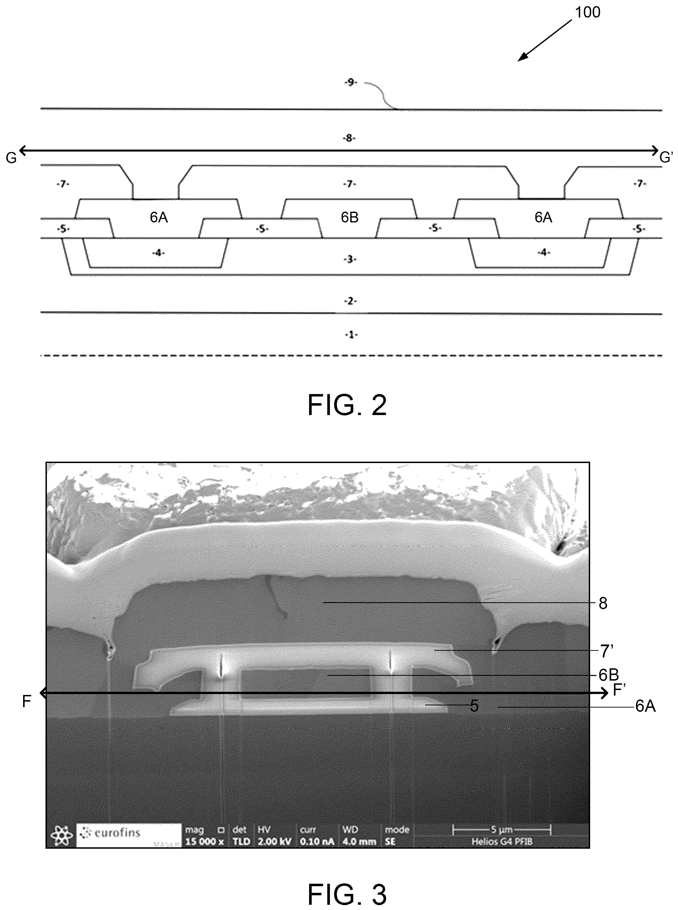

Figure 2 shows a cross-section of a vertical bipolar junction transistor (BJT) device according to an embodiment of the disclosure. In this embodiment, the device 100 includes an n-type voltage sustaining region or drift region 2 over a collector layer 1 of a semiconductor substrate. The collector layer 1 is a doped n-type region of the substrate, having a higher doping concentration than the drift region 2. Located above the drift region 2, there is provided a p-type base region (which may be referred to as a p-well or p-body region) 3.

Disposed within the base region 3, a plurality of n+ emitter contact regions 4 of the emitter are formed. The emitter contact regions 4 (referred to as emitter regions) have a higher doping concentration than the drift region 2. The emitter contact regions 4 are laterally spaced from each other within the base region 3. Both the emitter contact regions 4 and the base region 3 are located completely above the collector layer 1.

The semiconductor substrate includes the collector layer 1, the drift layer 2, and the base region 3 and emitter regions 4. A plurality of insulating regions 5 are formed over the top surface of the semiconductor substrate. The insulating regions 5 are each disposed at least partly over the emitter contact regions 4. The insulating regions 5 are laterally spaced from each other, and each insulating region 5 is in contact with a portion of a top surface of an emitter contact region 4 and a portion of a top surface of the base region 3. In this example, the insulating regions 5 are formed of an oxide region.

A plurality of metal contact regions (referred to as metal contacts) 6 are formed over a top surface of the semiconductor substrate. The metal contact regions 6 are laterally spaced from each other. The metal contact regions 6 may be formed of a patterned metal layer. A first plurality of contacts 6a of the metal contact regions 6 (also referred to as the emitter electrodes) are located over the emitter contact regions 4 such that each contact of the first plurality of contacts 6a is in contact with one emitter contact region 4. A second plurality of contacts 6b of the metal contact regions 6 (also referred to as the base electrodes) are located over the body region 3 such that each contact of the second plurality of contacts 6b is in contact with the body region 3. The emitter electrodes 6a are formed in the same plane as the base electrodes 6b.

The insulating regions 5 are located such that the insulating regions 5 electrically isolate contacts of the first plurality of contacts 6a from adjacent contacts of the second plurality of contacts 6b.

One or more further insulating regions (in this example, an interlayer dielectric) 7 are located at least partially over some of the insulating regions 5 and the first plurality of contacts 6b. Each interlayer dielectric region 7 completely covers one of the second plurality of contacts 6b and extends down between adjacent contacts of the first plurality of contacts 6a and contacts of the second plurality of contacts 6b, such that a lower surface of the interlayer dielectric region 7 is in contact with a plurality of the insulating regions 5. The interlayer dielectric region 7, in conjunction with the insulating regions 5 it is in contact with, forms a columnar structure of support pillars that isolates the contact 6b of the second plurality of contacts from the adjacent contacts 6a of the first plurality of contacts it is located between. The interlayer dielectric region 7 may partially extend over a top surface of one or more contacts of the first plurality of contacts 6a. This overhang portion of the interlayer dielectric region 7 increases the strength of the interlayer dielectric region 7 and the device.

A metal contact layer 8 is located over the interlayer dielectric 7 and the metal contact regions 6. The metal contact layer 8 completely covers the interlayer dielectric region 7 and extends down between adjacent interlayer dielectric regions 7, such that a lower surface of the metal contact layer is in contact with the first plurality of contacts 6a.

The plurality of metal contact regions 6 may be formed of a first metal. The metal contact layer 8 may be formed of a second metal. The first metal and the second metal may be the same metal, or they may be different metals.

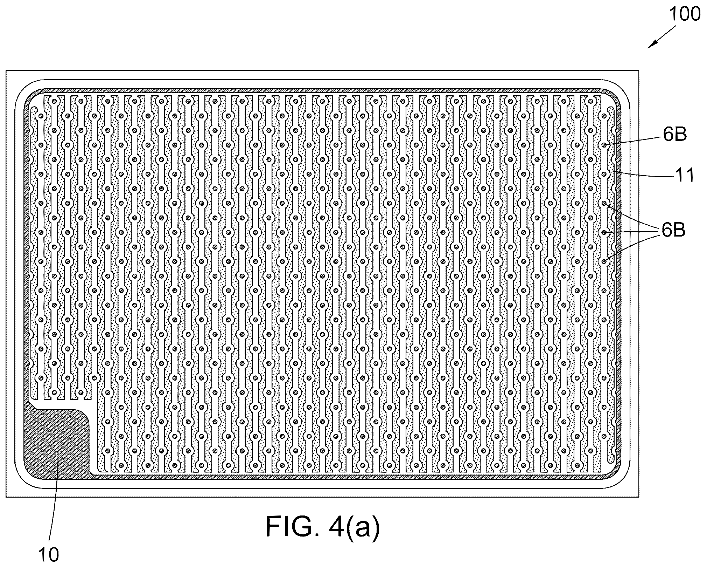

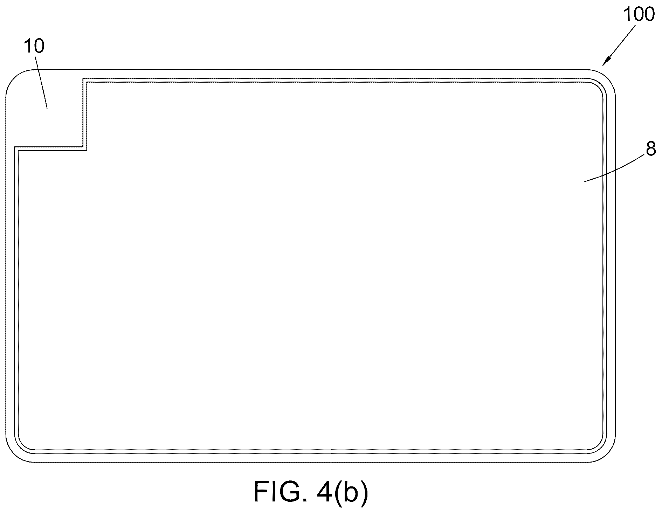

The conductivity and flow of the metal used when forming the metal contact layer 8 creates vias to the metal contact regions 6a, as shown in Figures 3 and 4. Alternatively, in some examples a plug (for example, a Tungsten plug) may be used to connect the two metals.

A further metal layer 9 is formed over the metal contact layer 8. In some examples, the further metal layer 9 may be a ribbon bond formed over a top surface of the device or may be connected to a ribbon bond. In this example, the ribbon bond includes an aluminium or gold ribbon bond. Due to the large cross-section of a ribbon bond compared to wire bonding, it can carry higher currents. For example, in a BJT device as disclosed, the use of a ribbon bond can increase the current performance by up to 10A.

In the herein disclosed device, multiple silicon dioxide pillars from the interlayer dielectric regions 7 contribute to supporting the ball or ribbon bond. The herein disclosed BJT device can therefore withstand increased forces caused by ribbon bonding.

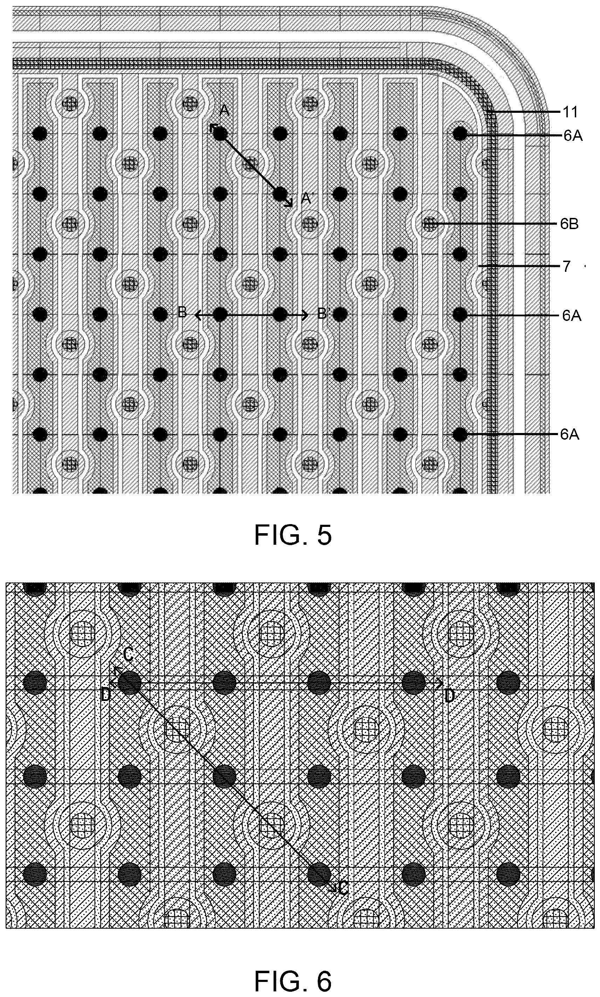

It will be appreciated that Figure 2 shows a cross-section through one portion of the BJT, and that the cross-section is not constant through the whole device. For example, Figure 2 illustrates a cross-section through the device shown in Figure 5 across the diagonal line A-A'.

Figure 3 shows a scanning electron microscope image of a cross-section of a BJT according to an embodiment of the disclosure. The BJT device shown in Figure 3 may be the same as the device shown in Figure 2, although the cross-section shown may be taken across a different area of the device. Many of the features therefore carry the same reference numerals as those of Figure 2. For example, Figure 3 illustrates a cross-section through the device shown in Figure 5 across the line B-B'.

In the example shown in Figure 3, the interlayer dielectric region 7 and the insulating regions 5 may be silicon dioxide, deposited via plasma-enhanced chemical vapour deposition (PECVD) using a tetraethyl orthosilicate (TEOS) precursor. The use of TEOS for the interlayer dielectric region 7 gives more conformal step coverage.

When depositing the interlayer dielectric region 7, the deposition is performed such that an upper dielectric region located over the support pillars has a thickness that is at least half the width of the support pillars. This ensures that breadloafing, which occurs when depositing the dielectric region, causes the gap between adjacent metal contacts 6A, 6B to be filled to form the support pillars.

An upper surface of the interlayer dielectric region 7 is then planarised such that an upper surface of the interlayer dielectric region 7 is substantially flat. This planarised upper surface of the interlayer dielectric region 7 transfers bonding forces to the multiple support pillars provided underneath the upper surface. The interlayer dielectric region 7 provides support for the base contact 6b underneath, and isolates the base metal contact 6b from the emitter contact 6a and the metal layer 8. The support pillars formed by the interlayer dielectric region 7 and insulating regions 5 (in this example, formed of silicon dioxide) are less compressible than the metal regions due to the absence of voids within the support pillars, and have a high density. This strengthens the device.

The spacing between adjacent metal contacts 6, the thickness of the support pillars and the sidewall angle improve the formation of dense support pillars. The configuration of the herein disclosed device allows the spacing between adjacent metal contacts 6 to be reduced compared to state-of-the-art devices. For example, adjacent base contacts 6b may be separated by 35 to 50µm. The support pillars may have a depth or thickness of around 4µm, and a width of the support pillars may be at least 2µm. The sidewall angle (the angle of the metal contacts 6 and the horizontal plane) is generally between 5° and 15°. This off-vertical metal sidewall angle promotes the formation of void free support pillars when deployed in conjunction with conformal ILD (interlayer dielectric) deposition technology such as PECVD (plasma enhanced chemical vapour deposition).

The planarised surface of the interlayer dielectric region 7 allows the metal contact layer 8 to be substantially flat such that the ribbon bond can be connected to the metal contact layer 8. The mechanical bonding process used to attach a ribbon bond is generally a gentler and less harsh process on the device compared to wire bonding, as it spreads the mechanical stress over a larger surface area of the device. Alternatively, wire bonding or clip bonding may be used.

Figure 4(a) shows a top-view of a BJT according to an embodiment of the disclosure, and Figure 5 shows a magnified top-view of the BJT shown in Figure 4. Figure 6 shows a further magnified view of the device of Figure 5. The view shown in Figure 4(a) may be a horizontal cross section through the device shown in Figure 3 along line F-F', where the upper metal contact layer has been omitted. The metal contacts 6b that are connected to the body region 3 (the base contacts) are arranged in a grid pattern of rows of metal contacts 6b. In this example, the rows are shown vertically. Each row of base contacts 6b are connected along the direction of the row of contacts 6b to a base pad 10 via a metal track 11. In the example shown, the base pad 10 is located at a periphery or edge of the device, and may formed outside of the active area of the device. In this example, the base pad 10 is located on a corner region of the device. Although it will be understood that the base pad 10 could be located in a different region of the device.

Whilst not shown in the figures, the connections between base contacts 6b within each row are formed in a lower layer of the device than the metal contact layer 8 such that the device has a dual layer metal structure. In state-of-the-art devices, a ribbon bond over a top surface of the device would short circuit the base contact 6b and the emitter contacts 6a, whereas the dual-layer metal structure allows the ribbon bond to be connected to the top surface of the device.

During operation of the device whilst flow to the base contact 6b moves laterally through the device, flow to the emitter contact 6a moves vertically from the metal layer 8. There is no requirement for interdigitated connections to emitter contacts 6a to be located between connections to base contacts 6b. This means that, in comparison to state-of-the-art devices, there is no lateral voltage drop across adjacent base contacts 6b and emitter contacts 6a. This provides a single cell geometry that can be used for multiple applications without requiring as much customisation as state-of-the-art devices.

In the example shown in Figure 4(a) and 5, the rows of base contacts 6b can be connected to the metal track 11 via connections running between a first side of the device and a second, opposite side of the device. In comparison to state-of-the-art devices in which base contacts are connected to the base pad along single-ended interdigitated connections, the base contacts 6b can be connected to two, opposite sides of the metal track 11. Therefore, the connections between the base contacts 6b and the metal track 11 are more uniform throughout the device. This improves the uniformity of the potential bias across the device and allows for quicker turn-off in regions of the device further from the base pad.

Similarly, as each of the emitter contacts 6a are connected vertically to the metal layer 8, this improves the uniformity of the emitter contacts and allows for an optimum emitter to base bias across the device. This also improves the turn-on speed of the device. This allows a larger device to be manufactured whilst still having quick turn-on and turn-off speeds. The switching speeds of the herein disclosed BJT devices can be comparable to MOSFETs.

The upper metal contact layer 8 connected to the metal contacts 6a that are connected to the emitter contact regions 4, extends over the surface of the device with the exception of the base contact 10 and the metal track 11, as shown in Figure 4(b). In the view of Figure 4(b), the upper metal layer 8 is visible. The view shown in Figure 4(b) may be a horizontal cross section through the device shown in Figure 2 along line G-G'. The upper metal layer 8 forms an emitter matrix layer that covers almost all the usable chip area, and thus has an increased surface area compared to state-of-the-art devices.

In comparison to state-of-the-art devices, there is no requirement for the active area of the device to be reduced in size to provide a region for an emitter bond area, as the metal layer 8 can be formed directly over the emitter contacts 6b in the active area of the device. This allows the size of the active area of the device to be significantly increased.

By having the base contact 10 only under a base pad, and the emitter matrix over the larger chip area, the device has an improved ESD performance.

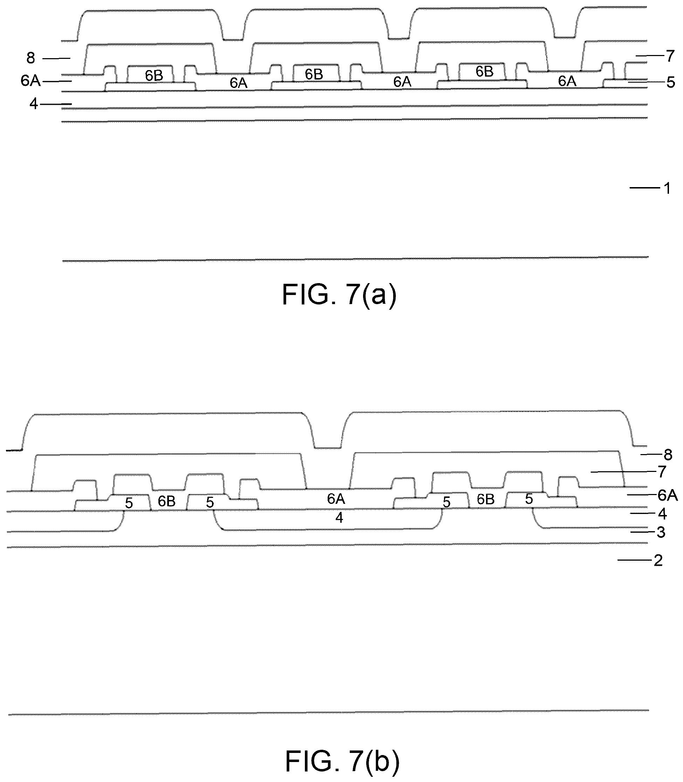

Figure 7(a) illustrates a cross-section through the device shown in Figure 6 across the diagonal line D-D'. The view of Figure 7(a) is similar to that shown in Figure 3. Figure 7(b) illustrates a cross-section through the device shown in Figures 5 and 6 across the diagonal line C-C'. The view of Figure 7(b) is similar to that shown in Figure 2. The features are similar to those shown in Figures 2 and 3, and therefore carry the same reference numerals.

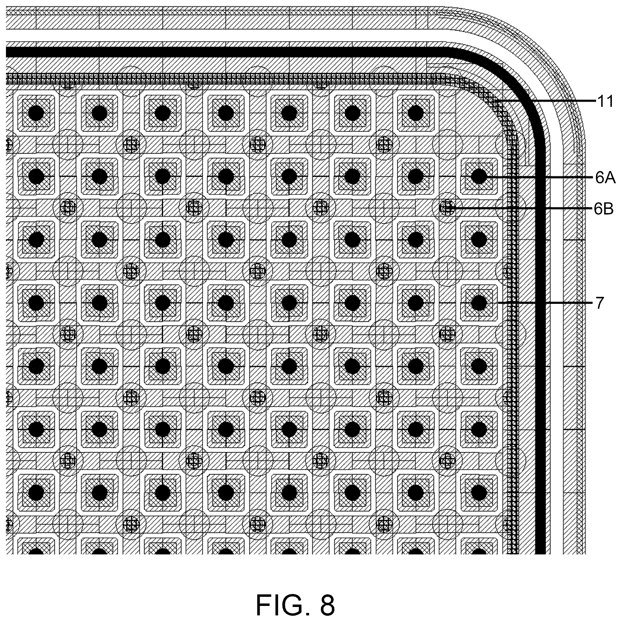

Figure 8 shows a magnified top-view of an alternative BJT according to an embodiment of the disclosure. In this view, the upper metal contact layer has been omitted. In this example, the base contacts 6b are arranged in a grid pattern. Whilst not shown, the connections from the base contacts 6b to the metal track are arranged in a mesh grid pattern. This further reduces the connection distance between the base contacts 6b and the metal track. Thereby further improving uniformity of on-state operation across the device, and reducing turn-off speed.

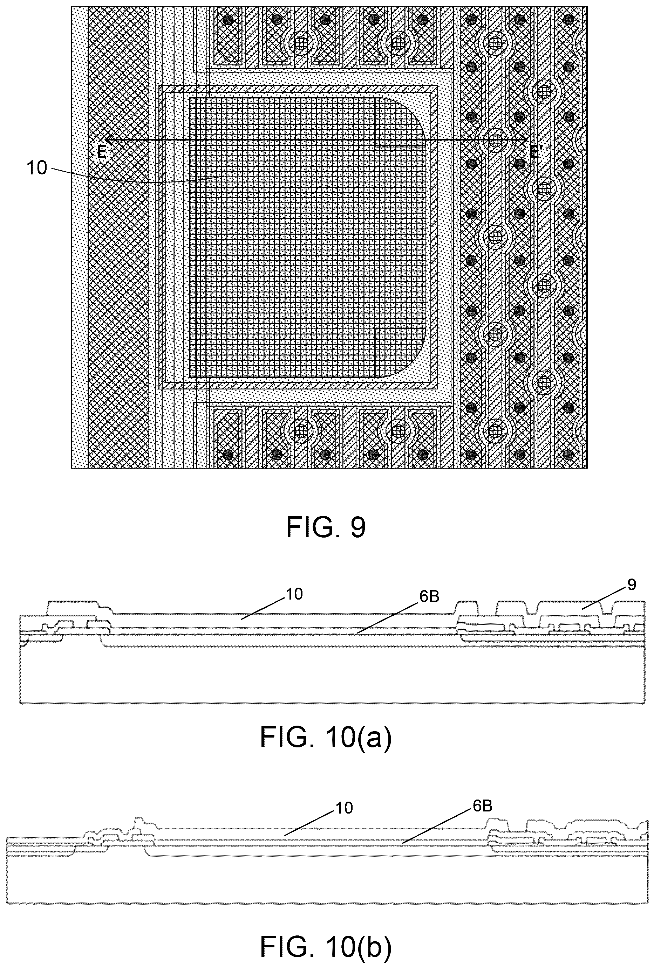

Figure 9 shows a magnified top-view of the base pad area of the BJT shown in Figure 4. The base pad 10 comprises a top metal layer that is connected to a base metal contact 6b. The base pad 10 and the base metal contact 6b in the base pad area have a larger area than the other base metal contacts 6b throughout the device. The base pad 10 is laterally spaced and insulated from the top metal layer 9. Figure 10(a) illustrates a cross-section through the device shown in Figure 9 across the diagonal line E-E'. Figure 10(b) illustrates an alternative cross-section through the device shown in Figure 9 across the diagonal line E-E'. Whilst the cross-section shown in Figure 10(b) is not shown as planarised, it would be understood that this embodiment may alternatively be planarised It will be understood that whilst the examples shown describe a n-p-n BJT device, the principles can also apply to a p-n-p BJT device. It will also be understood that while Figures 5 and 8 show two patterns of connections to the base contacts 6b, the invention is not limited to these two patterns.

In embodiments of the herein disclosed device, the bipolar junction transistor chip 100 features a large unbroken sheet of top metal 8, connected to the emitter region 4 of the transistor. Unlike existing semiconductor chips incorporating bipolar junction transistors, this allows a larger region of emitter-connected metal large enough without compromising the efficient delivery of base current, and/or delete active emitter area. The large unbroken area of the emitter metal contact on the top surface of the device is suitable for connecting to bond wires, a ribbon bond or a clip bond.

In some embodiments, emitter bond wires comprise circular cross-section wires generally formed of gold or copper, though they may comprise other materials. They are generally ultrasonically bonded to the emitter contact 8 of the device. In some examples, multiple wires can be bonded in parallel, to reduce the overall resistance contribution. Generally, 43µm diameter Copper wires may be used, each with a cross-sectional area of 1849µm².

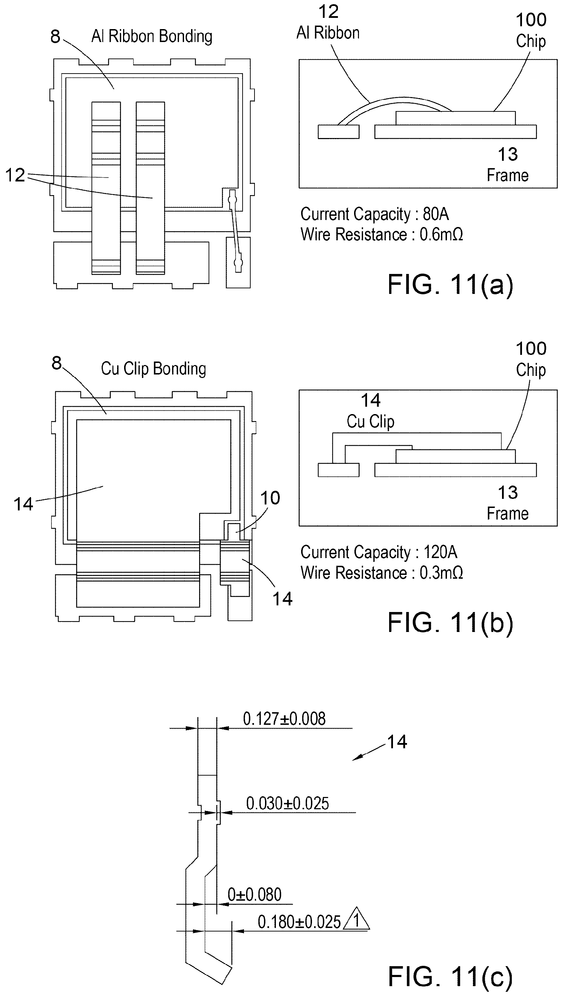

Alternatively, an emitter ribbon bond includes a rectangular cross-section ribbon 12, such as shown in Figure 11(a). Figures 11(a) illustrates schematically a top-view and side-view of a ribbon bond 12 to a semiconductor chip 100 arranged on a frame 13. This is generally formed of Aluminium, though other metal materials may be used. Each ribbon bond has significantly greater cross-sectional area versus individual wires. In embodiments, ribbon of 762µm width and 101µm uncompressed height may be used. In some embodiments, a ribbon bond of smaller width may be used, for example having a width of 508µm. The ribbon bond may have a first uncompressed height before bonding to the semiconductor chip, and a second, larger area in contact with the chip after being bonded to the chip. For example, ribbon of 762µm width and 101µm uncompressed height before bonding, may have 762µm width and 304µm height area in contact with the semiconductor chip.

The herein disclosed structure of the bipolar junction transistor allows larger semiconductor chips to be formed. In some examples, to facilitate ribbon bonding and/or clip bonding, an edge of the semiconductor chip may have a length of at least 0.25mm, more preferably at least 0.5mm, or even more preferably at least 1mm.

It is preferably for the ribbon bond not to be formed between cells.

Alternatively, an emitter clip bond 14 is shown in Figures 11(b) and 11(c). This includes a metal sheet (for example, copper) configured to be welded or soldered to the top emitter metal layer 8 of the chip. The metal sheet forming the clip 14 is shaped to be substantially congruent to the top emitter metal contact 8 of the device. This means that the contact area between the clip bond 14 and the chip is increased compared to other methods of electrical connection, and thus the electrical resistance through the clip bond reduced compared to other methods of electrical connection including ribbon bonding. The thickness of the metal sheet used for the clip bond may typically have a thickness or uncompressed height of 152µm (as compared to the 101µm thickness of an Al ribbon bond).

The clip bond may have a first uncompressed height before bonding to the semiconductor chip, and a second, larger area in contact with the chip after being bonded to the chip. For example, a clip bond of 830µm width and 152µm before bonding, may have 830µm width and 555µm height area in contact with the semiconductor chip after bonding.

Clip bonds, and in some examples ribbon bonds, may have a smaller width than the embodiments discussed above. However, reducing the size of the bond and chip means that it can handle reduced current. This reduces the advantage of using a ribbon or clip bond.

Figure 11(b) illustrates a device in which both the emitter contacts 6a and base contacts 6b are connected to via clip bonding through the base pad 10 and metal contact layer 8. Alternatively, clip bonding may be used for the emitter connection 6a, and a wire bond or other type of connection may be used for the base connection 6b through the base pad 9.

To connect the clip bond to the top metal layer of BJT device, the device can include a solderable top metal top liner; this may comprise a layer of silver or gold. The herein used clip bond structure improves current capacity and package resistance of the device.

Figure 11(c) shows a side view of a metal sheet (also referred to as a clip) for use in clip bonding. The clip has a thickness of 127µm. In the example shown, the clip is formed of steel (such as stainless steel), though it may be formed of another metal (such as copper).

Whilst the clip of Figure 11(c) has a thickness of 127µm before bonding, it may be thicker. For example, the clip can also be 203µm or 152µm thick.

### Reference Numerals

| | | | |
|---|---|---|---|
| 100 | Bipolar Junction Transistor 35 | 7 | dielectric region |
| 1 | collector region | 8 | metal contact layer |
| 2 | drift region | 9 | metal layer |
| 3 | body region | 10 | base pad |
| 4 | emitter contact region | 11 | metal track |
| 5 | insulating region 40 | 12 | ribbon bond |
| 6a | first metal contact | 13 | frame |
| 6b | second metal contact | 14 | clip bond |

## Claims

1. A bipolar junction transistor (BJT) comprising:
a semiconductor region, comprising:
a drift region of a first conductivity type;
a body region of a second conductivity type, opposite to the first conductivity type, disposed over the drift region;
one or more emitter regions of a first conductivity type disposed within the body region; and
a plurality of metal contacts, located on a top surface of the semiconductor region, wherein the plurality of metal contacts comprise one or more first metal contacts that are in contact with the one or more emitter regions and one or more second metal contacts that are in contact with an upper surface of the body region;
one or more insulating structures located on a top surface of the semiconductor region, wherein the insulating structures isolate the one or more first metal contacts from the one or more second metal contacts; and
a metal layer located over the insulating structures, wherein the metal layer is in contact with one or more first metal contacts and is isolated from the one or more second metal contacts by the insulating structures.

2. A bipolar junction transistor according to claim 1, wherein the one or more first metal contacts and the one or more second metal contacts are laterally spaced from each other in a first direction, and wherein the one or more second metal contacts are vertically spaced from the metal layer in a second direction, wherein the second direction is perpendicular to the first direction.

3. A bipolar junction transistor according to claim 2, wherein the bipolar junction transistor is configured such that, when in use, current flows vertically between the one or more first metal contacts and the metal layer, and current flows within the one or more second metal contacts laterally through the device.

4. A bipolar junction transistor according to claim 3, comprising a base terminal, and wherein the one or more second metal contacts are connected to the base terminal via a metal track extending along a perimeter of the bipolar junction transistor; and
optionally wherein each second metal contact of the one or more second metal contacts is connected to the metal track via a plurality of connections extending in at least two different directions; and/or
wherein each second metal contact of the one or more second metal contacts is directly connected to a portion of the metal track extending along a side of the bipolar junction transistor that is closest to said each second metal contact of the one or more second metal contacts.

5. A bipolar junction transistor according to any preceding claim, wherein the one or more insulating structures comprise:
a plurality of first insulating regions located on a top surface of the semiconductor region, wherein each first insulating region is located laterally between a first metal contact of the one or more first metal contacts and a second metal contact of the one or more second metal contacts; and
one or more dielectric regions located over the one or more second metal contacts, wherein the dielectric regions are at least partly located over the plurality of first insulating regions; and
optionally wherein the one or more dielectric regions overlap an upper surface of the one or more first metal contacts.

6. A bipolar junction transistor according to claim 5, wherein the one or more dielectric regions comprises an upper dielectric region supported by two or more laterally spaced columnar structures, wherein each columnar structure is formed over a first insulating region; and
optionally wherein a width of the two or more columnar structures is at least 2µm; and/or
wherein a spacing between adjacent columnar structures is 5µm to 20µm; and
optionally wherein a spacing between adjacent columnar structures is 12µm.

7. A bipolar junction transistor according to claim 5 or 6, wherein an upper surface of the one or more dielectric regions is planarised.

8. A bipolar junction transistor according to any preceding claim, wherein the insulating structures are formed of silicon dioxide.

9. A bipolar junction transistor according to any preceding claim, wherein the metal layer has a larger surface area than the one or more first metal contacts.

10. A bipolar junction transistor according to any preceding claim, further comprising a ribbon bond formed over the metal layer.

11. A bipolar junction transistor according to any of claims 1 to 10, further comprising a clip bond formed over the metal layer.

12. A bipolar junction transistor according to any preceding claim, wherein a spacing between adjacent second metal contacts of the one or more second metal contacts is between 20µm to 100µm; and
optionally wherein a spacing between adjacent second metal contacts of the one or more second metal contacts is between 35µm to 50µm.

13. A bipolar junction transistor according to any preceding claim, wherein an emitter terminal connection is formed on an upper surface of the device over the metal layer and extending substantially over the active area of the device; and
optionally further comprising a base terminal connection formed on an upper surface of the device, wherein the base terminal connection does not extend over the metal layer.

14. A method of manufacturing a bipolar junction transistor (BJT), the method comprising:
forming a semiconductor region, comprising:
a drift region of a first conductivity type;
a body region of a second conductivity type, opposite to the first conductivity type, disposed over the drift region;
one or more emitter regions of a first conductivity type disposed within the body region; and
forming a plurality of metal contacts, located on a top surface of the semiconductor region, wherein the plurality of metal contacts comprise one or more first metal contacts that are in contact with the one or more emitter regions and one or more second metal contacts that are in contact with an upper surface of the body region;
forming one or more insulating structures located on a top surface of the semiconductor region, wherein the insulating structures isolate the one or more first metal contacts from the one or more second metal contacts;
forming a metal layer located over the insulating structures, wherein the metal layer is in contact with the one or more first metal contacts and is isolated from the one or more second metal contacts by the insulating structures.

15. A method according to claim 14, wherein forming the one or more insulating structures comprises forming one or more dielectric regions comprising an upper dielectric region supported by two or more laterally spaced columnar structures, and wherein the upper dielectric region has a thickness that is at least half the width of the columnar structures; and
optionally wherein after forming the one or more dielectric regions, the method further comprises planarising an upper surface of the upper dielectric region.
